# NEUE EUROPÄISCHE PATENTSCHRIFT

(11) **EP 0 967 190 B2**
(45) Veröffentlichungstag und Bekanntmachung des Hinweises auf die Entscheidung über den Einspruch: **20.01.2010**
(45) Hinweis auf die Patenterteilung: 28.08.2002
(21) Anmeldenummer: 99112209.4
(22) Anmeldetag: 25.06.1999
(51) Int. Cl.: C04B 41/87, C04B 35/628, C04B 35/80, D01F 11/12, C22C 47/00, C23C 16/54

(54) **Verfahren zur Herstellung von beschichteten Kurzfasern**
Process for producing coated short fibers
Procédé de fabrication de fibres courtes revêtues

(30) Priorität: 27.06.1998 DE 19828843
(43) Veröffentlichungstag der Anmeldung: 29.12.1999
(73) Patentinhaber: Daimler AG, 70327 Stuttgart (DE)
(72) Erfinder: Linn, Horst, 92275 Eschenfelden (DE); Rebstock, Kolja, Dr., 89073 Ulm (DE); Emig, Gerhard, Prof. Dr., 91058 Erlangen (DE); Gerhard, Helmut, 90491 Nürnberg (DE); Popovska, Nadejda, Dr., 91058 Ulm (DE); Wunder, Volker, 91242 Ottensoos (DE)
(74) Vertreter: Brückner, Ingo Andreas

(56) Entgegenhaltungen:
- EP-A- 0 102 489
- EP-A- 0 864 548
- DE- - 3 933 039
- US- - 4 068 037
- US- - 4 315 968
- US-A- 4 315 968
- US-A- 4 960 643
- DATABASE WPI Section Ch, Week 9646 Derwent Publications Ltd., London, GB; Class E11, AN 1996-461205 XP002117647 & JP 08 231287 A (YAZAKI CORP), 10. September 1996 (1996-09-10)
- DATABASE COMPENDEX [Online] ENGINEERING INFORMATION, INC., NEW YORK, NY, US POPOVSKA N ET AL: "Chemical vapor deposition of titanium nitride on carbon fibres as a protective layer in metal matrix composites" Database accession no. EIX98304239816 XP002117646 & PROCEEDINGS OF THE 1997 E-MRS SPRING MEETING;STRASBOURG, FR JUN 16-20 1997, Bd. 18, Nr. 4-6, 16. Juni 1997 (1997-06-16), Seiten 239-242, Mater Des;Materials & Design; Symposium J: Light-Weight Materials for Transportation Dec 1997 Elsevier Sci Ltd, Exeter, Engl

## Beschreibung

Die vorliegende Erfindung betrifft ein Verfahren zur Herstellung von beschichteten Kurzfasern nach dem Oberbegriff von Anspruch 1 bzw. Anspruch 2 sowie mit diesem Verfahren herstellbare Kurzfasern.

Kurzfasern werden insbesondere zur Herstellung von faserverstärkten Verbundwerkstoffen, bspw. von faserverstärkten keramischen Verbundwerkstoffen (CMC) und von faserverstärkten Metallmatrix-Verbundwerkstoffen (MMC) verwendet. Die Faserverstärkung bewirkt eine Duktilisierung und somit eine erhöhte Schadenstoleranz der Matrix des Verbundwerkstoffes. Die zu diesem Zweck verwendeten Fasern sollen im allgemeinen allseitig mit einer Schutzschicht versehen sein. Diese Schutzschicht wird bspw. durch CVD-Beschichtung (CVD: chemical vapour deposition) oder durch Eintauchen in ein Bad auf der Faser abgeschieden und dient dazu, eine Reaktion der Fasern mit der Verbundwerkstoff-Matrix (Keramik oder Metall) zu verhindern. Die Fasern sollen nach Möglichkeit unverändert bzw. unbeschädigt in den Verbundwerkstoff eingelagert sein, um eine optimale Duktilisierung zu erreichen. Kurzfasern sind besonders gut zur Herstellung faserverstärkter Verbundwerkstoffe geeignet, da sie sich im Verbundwerkstoff ungeordnet in allen drei Raumrichtungen einlagern, so daß ein Verbundwerkstoff mit isotropen Materialeigenschaften resultiert.

Beschichtete Fasern sind grundsätzlich bekannt, z. Bsp. aus den prioritätsälteren, noch nicht veröffentlichten Patentanmeldungen Daim 28 320 und Daim 27 704. Auch die Technik der CVD-Beschichtung und der Tauchbadbeschichtung als solche ist bekannt. Bisher wurden allerdings nur Endlosfasern beschichtet, nicht jedoch Kurzfasern. Dies liegt daran, daß die kommerziell erhältlichen Fasern in Form von Faserbündeln vorliegen, die mit einer Schlichte überzogen sind, um den Zusammenhalt des Faserbündels zu gewährleisten. Vor der CVD-Beschichtung müssen die Faserbündel entschlichtet werden, so daß das Faserbündel zerfällt und die Fasern allseitig beschichtet werden können. Diese Entschlichtung erfolgt bei Endlosfasern thermisch, wobei die Endlosfasern kontinuierlich von einer Vorratsrolle abgewickelt, durch einen Ofen geleitet und anschließend wieder auf eine Vorratsrolle aufgewikkelt werden. Auf diese Weise bleiben auch die aus der Entschlichtung resultierenden Einzelfasern handhabbar.

Bei Kurzfasern ist dies hingegen nicht möglich. Durch die Entschlichtung zerfallen die Faserbündel in nicht mehr handhabbare, ungeordnete einzelne Fasern oder Filamente. Daher wurden zur Herstellung von beschichteten Kurzfasern zunächst wie beschrieben entschlichtete Endlosfasern beschichtet und anschließend zu Kurzfasern zerschnitten. Eine andere Alternative wäre, die Kurzfaserbündel direkt, d.h. ohne Entschlichtung zu beschichten. Die erste Alternative hat den Nachteil, daß die Schnittstellen unbeschichtet, d.h. ungeschützt vorliegen und somit mit der Verbundwerkstoff-Matrix reagieren können und oxidativem Angriff ausgesetzt sind. Die zweite Alternative hätte den Nachteil, daß sich die Schlichte störend auf die Materialeigenschaften des resultierenden faserverstärkten Verbundwerkstoffs auswirken würde. Die direkte Beschichtung von entschlichteten Kurzfasern wurde zwar immer wieder versucht bzw. vorgeschlagen, war aber bisher nicht durchführbar.

Aufgabe der Erfindung ist es somit, ein Verfahren der o.g. Art bereitzustellen, mit dem auch Kurzfaserbündel entschlichtet und allseitig CVD-beschichtet werden können bzw. mit dem durch Zerschneiden von beschichteten Endlosfasern hergestellte Kurzfasern an den Schnittstellen beschichtet werden können.

Die Lösung besteht in einem Verfahren mit den Merkmalen des Anspruchs 1 bzw. des Anspruchs 2.

Erfindungsgemäß ist also vorgesehen, daß die mit einer Schlichte überzogenen Kurzfaserbündel in einem Reaktor einem Hochfrequenzwellen-Feld ausgesetzt werden. Beim Eintrag der Kurzfaserbündel in die Wellenzone des Reaktors wird die anhaftende Schlichte schlagartig in gasförmige Produkte zersetzt. Die entstehende Gasphase treibt die einzelnen Fasern zusätzlich auseinander. Anschließend werden die so vereinzelten Fasern mindestens einem in der Gasphase vorliegenden Beschichtungsmittel ausgesetzt und im Hochfrequenzwellen-Feld CVD-beschichtet.

Das erfindungsgemäße Verfahren erlaubt es auch, aus beschichteten Endlosfasern durch Zerschneiden hergestellte Kurzfasern an ihren Schnittstellen zu beschichten. Dabei werden die Fasern ebenfalls in einem Hochfrequenzwellen-Feld aus mindestens einem in der Gasphase vorliegenden Beschichtungsmittel CVD-beschichtet. Auf diese Weise werden die Schnittstellen versiegelt, so daß sie nicht mehr mit der Verbundwerkstoff-Matrix reagieren können und gleichzeitig gegen Oxidation geschützt sind.

Durch das erfindungsgemäße Verfahren ist es somit erstmals möglich, Kurzfasern direkt allseitig zu beschichten. Das erfindungsgemäße Verfahren ist nicht substratspezifisch, das heißt, es können Fasern aller Art beschichtet werden.

Die mit dem erfindungsgemäßen Verfahren herstellbaren allseitig beschichteten Kurzfasern sind vor einer Reaktion mit der Verbundwerkstoff-Matrix geschützt und werden somit chemisch unverändert in die Matrix eingelagert. Die Beschichtung wirkt als Diffusionsund Reaktionsbarriere. Der resultierende Verbundwerkstoff zeichnet sich somit durch verbesserte mechanische Eigenschaften, insbesondere eine erhöhte Duktilität und demzufolge durch eine erhöhte Festigkeit und Schadenstoleranz aus. Die Beschichtung verbessert außerdem auch die Benetzbarkeit der Faseroberflächen durch die Matrix. Dies ermöglicht einen höheren Volumenanteil der Faserkomponente im Verbundwerkstoff, insbesondere bei keramischen Verbundwerkstoffen. Ferner werden die Einzelfasern in der Matrix homogener verteilt als die bisher verwendeten beschichteten Faserbündel. Bei der Herstellung von Metallmatrix-Verbundwerkstoffen durch Gasdruck-Schmelzinfiltration kann infolge der verbesserten Benetzbarkeit der Infiltrationsdruck auf bis zu etwa 1/10 des bisherigen Werts gesenkt werden.

Vorteilhafte Weiterbildungen ergeben sich aus den Unteransprüchen. Vorzugsweise werden Kohlenstoff-Fasern, insbesondere Recyclat-Kurzfasern verwendet. Recyclat-Fasern, welche durch Shreddern von faserverstärkten Kunststoffen gewonnen werden, können durch das erfindungsgemäße Verfahren von der ihnen anhaftenden Kunststoff-Matrix befreit werden. Dazu eignet sich besonders gut eine kombinierte Hochfrequenzwellen-, Ultraschall- und/oder Stoßwellenbehandlung.

Eine weitere vorteilhafte Weiterbildung sieht vor, daß die mit einer Schlichte bzw. einer Kunststoff-Matrix überzogenen Kurzfaserbündel vor dem Eintrag in das Hochfrequenzwellen-Feld zuerst mechanisch aufgelockert werden. Dadurch wird die nachfolgende Entschlichtung erleichtert.

Als Hochfrequenzwellen kommen vorzugsweise Mikrowellen zur Anwendung.

Bei der Schutzschicht kann es sich um Pyro-C-, SiC- und/oder Si-Schichten, aber auch um TiN-, TiC- und/oder TiCN-Schichten handeln. Durch das erfindungsgemäße Verfahren können Kohlenstoff-Kurzfasern mit einer Pyrokohlenstoff-Schicht sowie mit einer C-gradierten und/oder Si-gradierten Siliziumcarbid-Schicht bzw. mit einer C-gradierten und/oder N-gradierten Titancarbonitrid-Schicht beschichtet werden. Diese gradierten Schichten werden vorzugsweise in einem Beschichtungsschritt durch Variation der Abscheidungsparameter abgeschieden.

Zur Herstellung siliziumhaltiger Beschichtungen wird z. Bsp. Methyltrichlorsilan/Wasserstoff als Beschichtungsmittel verwendet. Zur Herstellung titanhaltiger Beschichtungen eignet sich z. Bsp. Titantetrachlorid mit Stickstoff und ggf. Methan in Wasserstoff als Beschichtungsmittel.

Die Dicke der Beschichtung kann durch die Verweilzeit der Fasern im Reaktor gesteuert werden. Dies ist z. Bsp. bei der Versiegelung der Schnittstellen von konventionell aus beschichteten Endlosfasern gewonnenen Kurzfasern von Vorteil, da zur Versiegelung eine dünne Beschichtung der Schnittstellen ausreicht.

Im folgenden werden Ausführungsbeispiele der vorliegenden Erfindung anhand der beigefügten Zeichnungen näher beschrieben. Es zeigen:
- Figur 1: eine schematische Darstellung einer Vorrichtung zur Erzeugung von allseitig beschichteten Kurzfasern aus Kurz faserbündeln;
- Figur 2: eine schematische Darstellung einer Vorrichtung zur mechanischen Auflockerung von Kurzfaserbündeln;
- Figur 3: eine schematische Darstellung eines Reaktorrohrs;
- Figur 4: eine schematische Darstellung der Neigung des Reaktorrohrs;
- Figur 5: eine schematische Darstellung einer Vorrichtung zur Erzeugung von allseitig beschichteten Kurzfasern aus Langfasern;
- Figuren 6a bis 6c: lichtmikroskopische Aufnahmen von kommerziellen C-Kurzfasern, jeweils unbehandelt, mechanisch behandelt und mit Mikrowellen behandelt;
- Figuren 7a bis 7c: lichtmikroskopische Aufnahmen von Recyclat-C-Kurzfasern; jeweils unbehandelt, mechanisch behandelt und mit Mikrowellen behandelt;
- Figuren 8a und 8b: REM-Aufnahmen von C-Kurzfasern, beschichtet mit TiN Fig. 8a) bzw. SiC (Fig. 8b);
- Figuren 9a und 9b: REM-Aufnahmen von kurzfaserverstärkten keramischen Verbundwerkstoffen mit unbeschichteten Kurzfasern (Fig. 9a) bzw. beschichteten Kurzfasern (Fig. 9b);
- Figur 10: ein Spannungs-Dehnungs-Diagramm von Keramiken mit und ohne Faserverstärkung;
- Figur 11: eine Darstellung der mechanischen Eigenschaften langfaserverstärkter Metallmatrix-Verbundwerkstoffe.

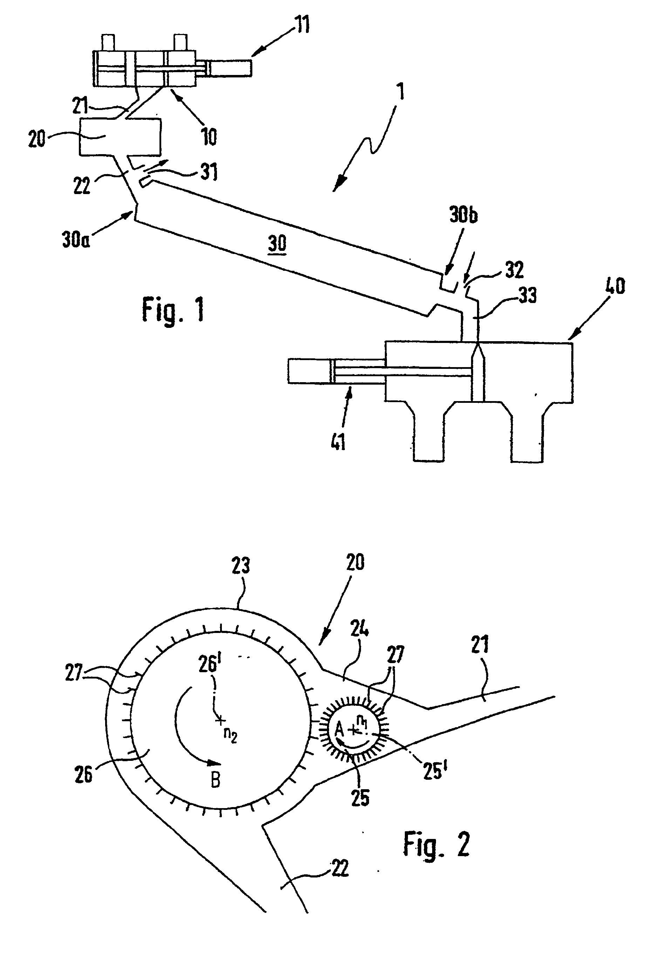

Figur 1 zeigt eine schematische Darstellung einer Vorrichtung 1 zur Durchführung des erfindungsgemäßen Verfahrens. Die Vorrichtung 1 dient zur allseitigen Beschichtung von Kurzfasern aus Kurzfaserbündeln. Die Vorrichtung 1 weist einen mit einer pneumatischen Vorlagenwechseleinrichtung 11 versehenen Vorratsbehälter 10 für Kurzfaserbündel auf. Der Vorratsbehälter 10 kann mit einer Rütteleinrichtung versehen sein, welche die Kurzfaserbündel in Bewegung hält. An den Vorratsbehälter 10 schließt sich eine Vorrichtung 20 zur mechanischen Auflockerung der Kurzfaserbündel auf. Die Vorrichtung 20 kann ebenfalls eine Rütteleinrichtung aufweisen und ist über einen Zufuhrschacht 21 für den Faserbündel-Eintrag mit dem Vorratsbehälter 10 verbunden und mündet über eine Drehdurchführung 22 für den Faserbündel-Austrag in den eigentlichen Reaktor 30 in Form eines drehbaren Reaktorrohrs, in dem die Faserbündel gemäß dem erfindungsgemäßen Verfahren allseitig beschichtet werden. Der Reaktor 30 weist an seinem oberen Ende 30a, in Nachbarschaft der Drehdurchführung 22 eine Öffnung 31 für die Reaktionsgasabfuhr und an seinem unteren Ende 30b eine weitere Öffnung 32 für die Reaktionsgaszufuhr auf. Der Reaktor 30 kann innerhalb der Vorrichtung 1 ausgewechselt werden, z. Bsp. gegen einen Reaktor mit anderen Abmessungen. In den Reaktor 30 mündet an seinem unteren Ende 30b ferner ein Materialaustrag 33, welcher den Reaktor 30 mit einer Auffangvorrichtung 40 für die allseitig beschichteten Fasern verbindet. Die Auffangvorrichtung 40 ist ebenfalls mit einer pneumatischen Vorlagenwechseleinrichtung 41 ausgestattet. Die Vorlagenwechseleinrichtungen 11, 41 dienen dazu, das im Reaktor 30 zur CVD-Beschichtung notwendige Vakuum zu gewährleisten und den Eintritt von Fremdgas in den Reaktor 30 zu verhindern.

Figur 2 zeigt eine schematische Darstellung der Vorrichtung 20 zur mechanischen Auflockerung der Faserbündel. Die Vorrichtung 20 hat die aus der Textilindustrie bekannten Faserkrempelmaschinen zum Vorbild. Sie besteht im wesentlichen aus einem Gehäuse 23 mit einer trichterförmigen Erweiterung 24, in welche der Zufuhrschacht 21 für den Faserbündel-Eintrag mündet. Im Gehäuse 23 ist in Höhe der Mündung 24 eine langsam laufende Zuführungs-Nadelrolle 25 angeordnet, welche sich im Ausführungsbeispiel im durch den Pfeil A angedeuteten Uhrzeigersinn langsam um ihre Längsachse 25' dreht. Die Drehgeschwindigkeit n₁ beträgt im Ausführungsbeispiel etwa 5 bis 10 U/min. Unmittelbar neben der Zuführungs-Nadelrolle 25 ist eine schnell laufende Abnehmer-Nadelrolle 26 angeordnet. Die Abnehmer-Nadelrolle dreht sich gegensinnig zur Zuführungs-Nadelrolle 25, im Ausführungsbeispiel also im durch den Pfeil B angedeuteten Gegenuhrzeigersinn, um ihre Längsachse 26'. Die Drehgeschwindigkeit n₂ ist deutlich höher als die Drehgeschwindigkeit n₁ und beträgt im Ausführungsbeispiel etwa 5000 bis 10000 U/min. Beide Rollen sind mit festen Edelstahlnadeln 27 bestückt. Ihr Abstand zueinander, also der Abstand zwischen den beiden Drehachsen 25' und 26' ist variabel und kann vom Fachmann je nach Bedarf eingestellt werden. Die Konfiguration der Vorrichtung 20, also die Breite der Rollen 25 und 26, ihr Abstand voneinander, ihre Drehgeschwindigkeit und die Dichte der Bestückung mit den Edelstahlnadeln 27, kann vom Fachmann an die Menge und Art der zu behandelnden Kurzfaserbündel angepaßt werden. Anstelle von Nadelrollen sind auch Rollen mit zahnförmigen, leistenförmigen, noppenförmigen und/oder ähnlichen Aufsätzen denkbar.

Die Drehdurchführung 22 mündet auf der Höhe der Abnehmer-Nadelrolle 26 in das Gehäuse 23 der Vorrichtung 20. Die Drehdurchführung 22 ist etwa im rechten Winkel zum Zufuhrschacht 21 angeordnet.

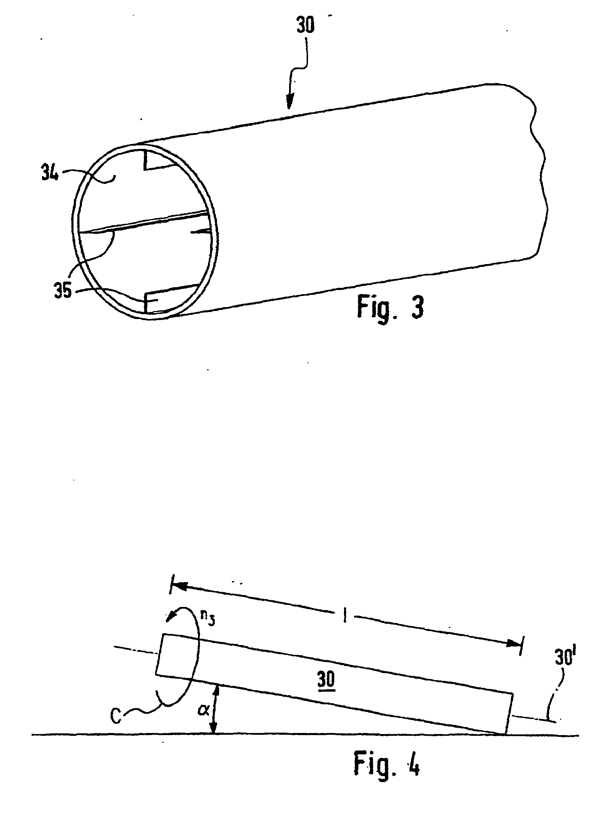

Figur 3 zeigt eine schematische Darstellung des Reaktors 30. Der Reaktor 30 ist eigentlich ein drehbares Reaktorrohr und besteht aus einem Material, welches nicht mit Mikrowellen koppelt, bspw. Al₂O₃, Quarz oder Teflon. Ein geeignetes Material ist z. Bsp. Alsint, eine Oxidkeramik aus Sinterkorund (Al₂O₃). An der Innenfläche 31 des Reaktors 30 sind Fasermitnehmer 32 angeordnet. Die Fasermitnehmer 32 können von verschiedener Form sein, z. Bsp. Stege, Wölbungen, Einbuchtungen und andere. Die Fasermitnehmer 32 können freistehend, in das Rohr des Reaktors 30 hineinragend oder auch gegenläufig zum Reaktor 30 drehend angeordnet sein. Der Reaktor 30 ist vorzugsweise, wie in Figur 4 gezeigt, um einen Neigungswinkel a zur Horizontalen geneigt angeordnet und hat eine Länge l. Der Reaktor 30 dreht sich mit einer Drehgeschwindigkeit n₃ in Richtung des Pfeils C um seine Längsachse 30'. Die Verweildauer der zu behandelnden Faserbündel bzw. Fasern im Reaktor kann vom Fachmann über die Länge l, den Neigungswinkel a und die Drehgeschwindigkeit n₃ gesteuert werden.

Die Beheizung des Reaktors erfolgt mittels eines Hochfrequenzwellen-Felds, vorzugsweise eines Mikrowellenfelds. Eine Ausführungsform dieses Prinzips, nämlich die Kombination einer Mikrowellenbeheizung mit einem homogenen Feld nach dem Prinzip eines Mikrowellen-Durchlaufofens mit einem mikrowellentransparenten Prozeßrohr ist in der deutschen Patentschrift DE 37 06 336 C1 beschrieben. Eine vergleichbare Beheizung ist ferner in der WO 94/26077 beschrieben. Zusätzlich kann eine Prozeßstützheizung vorgesehen sein, z. Bsp. über eine Induktionsheizung und einen Suszeptor und/oder einen mikrowellenankoppelnden Strahlungsheizer.

Ein geeigneter Mikrowellen-Durchlaufofen ist bspw. in der beiliegenden prioritätälteren unveröffentlichten Patentanmeldung beschrieben.

Im Ausführungsbeispiel wurden Kurzfasern von etwa 3 bis 30 mm Länge wie folgt beschichtet. Kommerziell erhältliche, mit einer Schlichte versehene Kurzfaserbündel oder Recyclatfaserbündel wurden aus dem Vorratsbehälter 10 durch den Zufuhrschacht 21 der Vorrichtung 20 zugeführt. Durch die Bewegung der Rollen 25, 26 (Drehgeschwindigkeiten: n₁: 6 U/min; n₂: 6000 U/min) und die Einwirkung der Nadeln 27 werden die Faserbündel transportiert und mechanisch aufgelockert. Am Ende der Abnehmer-Nadelrolle 26 fallen die aufgelockerten Faserbündel begünstigt durch die Zentrifugalkraft und den reduzierten Druck und ggf. unterstützt durch einen Inertgasstrom in die Drehdurchführung 22 und von dort in den Reaktor 30.

Der Reaktor 30 hatte einen Neigungswinkel a von 45° und eine Drehgeschwindigkeit n₃ von 5 bis 10 U/min. Innerhalb des Reaktors 30 war ein Mikrowellenfeld aufgebaut. Durch die Öffnung 32 wurde gleichzeitig Reaktionsgas in den Reaktor 30 geführt, welches über die Öffnung 31 wieder austrat. Beim Eintrag der Faserbündel in die Mikrowellenzone wurde die anhaftende Schlichte (bei den kommerziell erhältlichen Faserbündeln) bzw. die anhaftende Matrix (bei den Recyclatfaserbündeln) schlagartig zu gasförmigen Produkten zersetzt, so daß die Einzelfasern voneinander getrennt wurden. Die entstehende Gasphase trieb die Einzelfasern zusätzlich auseinander. Die Einzelfasern wurden anschließend aus dem Reaktionsgas CVD-beschichtet. Der Reaktor 30 wird dabei durch die Mikrowellenheizung mit homogenem Feld und/oder durch Induktivbeheizung beheizt.

Die beschichteten Einzelfasern gelangten aus dem Reaktor 30 durch den Materialaustrag 33 in die Auffangvorrichtung 40.

Zur Vereinzelung der Fasern aus den Faserbündeln kann auch eine kombinierte Mikrowellen-, Ultraschall- und/oder Stoßwellenbehandlung eingesetzt werden. Bei langen Verweilzeiten im Reaktor 30 (z. Bsp. bei großer Länge 1 und/oder kleinem Neigungswinkel a) ist ein Einsatz von Stoßwellen vorteilhaft, durch den die Fasern im Reaktor 30 in der Schwebe gehalten werden.

Je nach Art der Fasern und gewünschter Beschichtung können die Reaktionsbedingungen variieren. Bei Kohlenstoff-Kurzfasern bieten sich insbesondere Beschichtungen aus Titannitrid (Reaktionsgas: TiCl₄/H₂/N₂), Pyrokohlenstoff (Reaktionsgas: H₂/CH₄), Siliziumcarbid (Reaktionsgas: CH₃SiCl₃(MTS)/H₂) oder gradierten C/SiC/Si-Schichten (Reaktionsgas: CH₃SiCl₃(MTS)/H₂) an. Bei der Beschichtung mit Titannitrid bzw. Siliziumcarbid laufen die folgenden Reaktionen ab:

TiCl₄ + ½ N₂ + 2 H₂ → TiN + 4 HCl

CH₃SiCl₃ + H₂ → SiC + HCl + H₂

Die Reaktionsbedingungen für verschiedene Schichttypen sind in der folgenden Tabelle 1 exemplarisch aufgeführt.

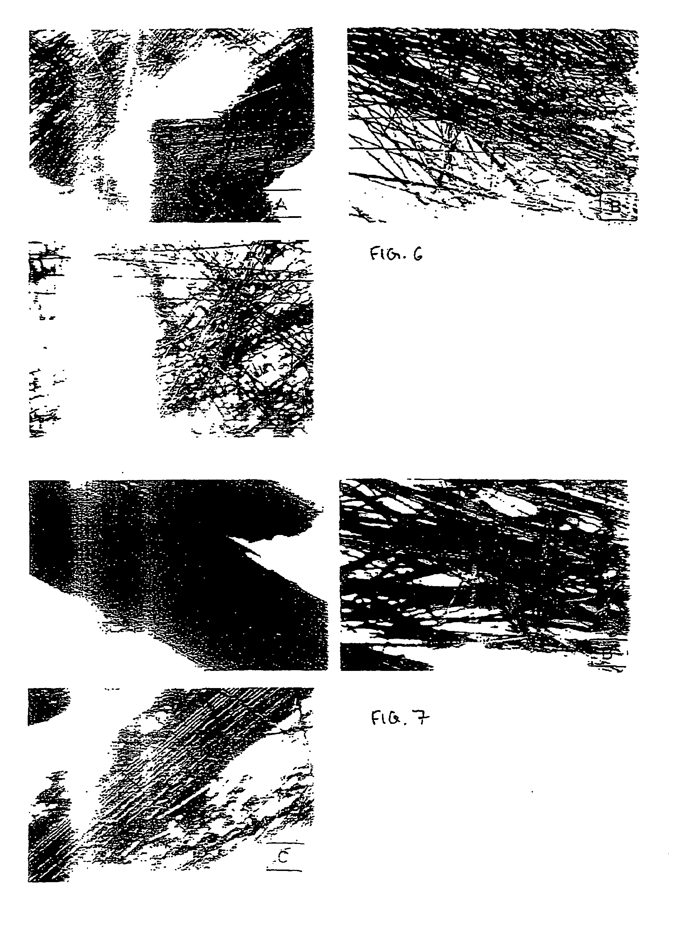

Die Figuren 6a bis 6c zeigen lichtmikroskopische Aufnahmen von kommerziell erhältlichen, mit einer Schlichte versehenen Kohlenstoff-Faserbündel im Rohzustand (Figur 6a), nach der mechanischen Auflockerung (Figur 6b) und nach der Vereinzelung der Fasern im Mikrowellenfeld (Figur 6c). Die Figuren 7a bis 7c zeigen entsprechende Aufnahmen von Recyclat-Kohlenstoff-Faserbündeln. Die Auflockerung der Faserbündel bzw. die Vereinzelung der Fasern ist deutlich zu erkennen. Die Vereinzelung bewirkt, daß jede Einzelfaser allseitig CVD-beschichtet werden kann.

**Tabelle 1**

| Schicht | TiN | Pyro-C | C/SiC/Si | SiC |
|---|---|---|---|---|
| T (°C) | 1150 | 1250 | 900-1200 | 1000 |
| P_{(gesamt)} (bar) | 1 | 0.1-1 | 1 | 1 |
| H₂/N₂ | 4 | - | - | - |
| H₂/CH₄ | - | 3 | - | - |
| H₂/MTS | - | - | 8 | 4 |
| Molenbruch Edukt | 0,02 | 0,05 | 0,06 | 0,06 |
| V_{(Strömung)} (cm/s) (NB) | 4 | 3 | 4 | 4 |

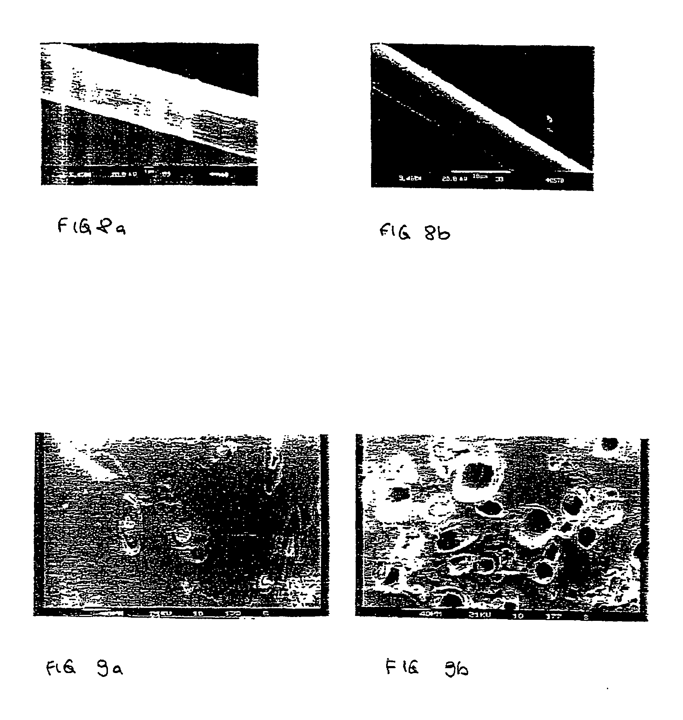

Die Figuren 8a und 8b zeigen erfindungsgemäß beschichtete Fasern, und zwar mit einer TiN-Schicht (Figur 8a) bzw. mit einer SiC-Schicht (Figur 8b). Die Schichten sind 15 bis 30 nm dick. Sie sind dicht, durchgehend und bilden die Faseroberfläche nach.

Durch Variation der Abscheidungsparameter, insbesondere Temperatur und Zusammensetzung des Reaktionsgasgemisches, können in einem Beschichtungsschritt gradierte Schichten auf die Fasern aufgebracht werden. Darunter werden hier Schichten verstanden, die in ihrer Zusammensetzung von reinem Kohlenstoff über Siliziumcarbid zu reinem Silizium übergehen bzw. die von Titancarbid über Titancarbonitrid zu Titannitrid übergehen. Die Variation der Reaktionstemperatur begünstigt dabei einen kontinuierlichen Übergang zwischen den einzelnen Zusammensetzungen, da Temperaturänderungen relativ langsam im Bereich von Minuten erfolgen. Die Änderung des Reaktionsgasgemisches erfolgt innerhalb einiger Sekunden durch Änderung der Volumenströme bei der Reaktionsgaszuführung innerhalb verschiedener Reaktorabschnitte. Damit geht ebenfalls ein kontinuierlicher Übergang zwischen den einzelnen Zusammensetzungen einher.

Somit kann der Fachmann durch Variation der chemischen Zusammensetzung der abgeschiedenen Schichten das Interface in faserverstärkten Verbundwerkstoffen an die verwendete Matrix anpassen. Auf Kohlenstoff-Fasern können bspw. C- und/oder Si-gradierte Siliziumcarbid-Schichten aus MTS/H₂ bzw. C- und/oder N-gradierte Titancarbonitrid-Schichten aus TiCl₄/CH₄/N₂/H₂ abgeschieden werden.

In den Tabellen 2 und 3 sind die chemischen Zusammensetzungen von gradierten Siliziumcarbid-Schichten (Tabelle 2) und gradierten Titancarbonitrid-Schichten (Tabelle 3) in Abhängigkeit der Abscheidungsbedingungen dargestellt.

**Tabelle 2**

| Temperatur, °C | H₂/MTS-Verhältnis | Schichtzusammensetzung |
|---|---|---|
| 900 | 2 | SiC |
| 900 | 4 | SiC + Si |
| 900 | 8 | Si |
| 1050 | 2 | SiC + C |
| 1050 | 4 | SiC |
| 1050 | 8 | SiC + Si |
| 1200 | 2 | C |
| 1200 | 4 | SiC + C |
| 1200 | 8 | SiC |

**Tabelle 3**

| Temperatur, °C | Reaktionsgas-Zusammensetzung | Schichtzusammensetzung |
|---|---|---|
| 1000 | TiCl₄/CH₄/N₂/H₂ | TiC_{0,3}N_{0,7} |
| 1100 | TiCl₄/CH₄/N₂/H₂ | TiC_{0,7}N_{0,3} |
| 1200 | TiCl₄/N₂/H₂ | TiN |
| 1050 | TiCl₄/CH₄/N₂/H₂ | TiCN |
| 1100 | TiCl₄/CH₄/N₂/H₂ | TiC_{0,7}N_{0,3} |
| 1100 | TiCl₄/CH₄/H₂ | TiC |

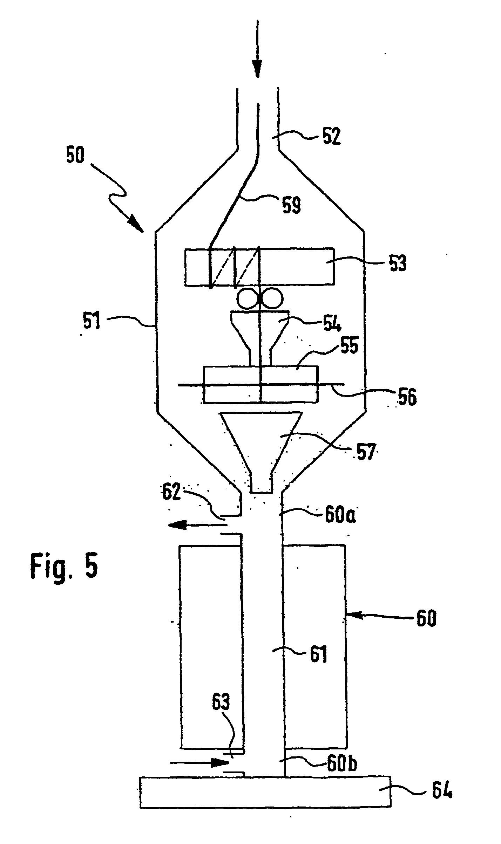

Figur 5 zeigt eine weitere Vorrichtung 50 zur Herstellung von allseitig beschichteten Kurzfasern aus Endlosfasern. Die Vorrichtung 50 schließt sich an eine bekannte CVD-Beschichtungsanlage für Endlosfasern an, in welcher die Fasern kontinuierlich zunächst durch einen Widerstandsofen zur Entschlichtung und dann durch einen IR-Ofen zur CVD-Beschichtung geführt werden. Der IR-Ofen ist über eine Mündung 52 mit dem Gehäuse 51 der Vorrichtung 50 verbunden. In der Nähe der Mündung 52 ist eine Rolle 53 angeordnet, auf welcher die durch die Linie 59 angedeuteten beschichteten Endlosfasern teilaufgewickelt werden. Die Endlosfasern 59 werden anschließend durch einen Führungstrichter 54 zu einer mit einem Messer 56 ausgestatteten Schneidevorrichtung 55 geführt, in welcher sie zu Kurzfasern zerschnitten werden. Die Kurzfasern fallen durch einen Leittrichter 57 in einen Nachbeschichtungsreaktor 60 mit einem vertikal angeordneten Reaktorrohr 61. Der Nachbeschichtungsreaktor 60 weist an seinem oberen, der Schneidvorrichtung 55 zugewandten Ende 60a eine Reaktionsgasabführung 62 und an seinem unteren Ende 60b eine Reaktionsgaszuführung 63 auf. Die Verweilzeit der Kurzfasern wird über die Länge des Reaktorrohrs 61 gesteuert. An den Nachbeschichtungsreaktor schließt sich eine Auffangvorrichtung 64 an.

Im Ausführungsbeispiel wurden allseitig beschichtete Kurzfasern aus Endlosfasern wie folgt hergestellt. Endlose Kohlenstoff-Fasern (Tenax HTA 5331, 6000 Filamente, Fa. Akzo) wurden in einem Widerstandsofen bei 900°C im Inertgasstrom entschlichtet und anschließend in einem IR-Ofen mit etwa 15 bis 20 nm dicken Schichten beschichtet.

In der folgenden Tabelle 4 sind die Abscheidungsbedingungen für verschiedene Schichttypen bei einer Faserdurchzugsgeschwindigkeit von etwa 90 bis 130 m/h zusammengestellt.

**Tabelle 4**

| Schicht | TiN | Pyro-C | C/SiC/Si | SiC |
|---|---|---|---|---|
| T (°C) | 1150 | 1250 | 900-1200 | 1000 |
| P_{(gesamt)} (bar) | 1 | 1 | 1 | 1 |
| H₂/N₂ | 4 | - | - | - |
| H₂/CH₄ | - | 3 | - | - |
| H₂/MTS | - | - | 2-8 | 4 |
| Molenbruch Edukt | 0,02 | 0,05 | 0,06 | 0,0,6 |
| v_{(Strömung)} (cm/s) (NB) | 4 | 3 | 4 | 4 |

Die fertig beschichteten Fasern wurden in der in Figur 5 gezeigten Vorrichtung in variable Längen geschnitten und in der Nachbeschichtungsanlage wie bereits für die Kurzfasern beschrieben im Mikrowellenfeld nachbeschichtet. Dadurch wurden die freien Schnittstellen versiegelt. Die Verweilzeit der geschnittenen Fasern im Nachbeschichtungsreaktor ist kürzer als diejenige der Kurzfaserbündel in der in Figur 1 gezeigten Vorrichtung. Die bei der Nachbeschichtung erzielten Schichtdicken zur Versiegelung der Schnittstellen betragen daher nur etwa 5 bis 6 nm. Dies reicht für den Versiegelungseffekt aus.

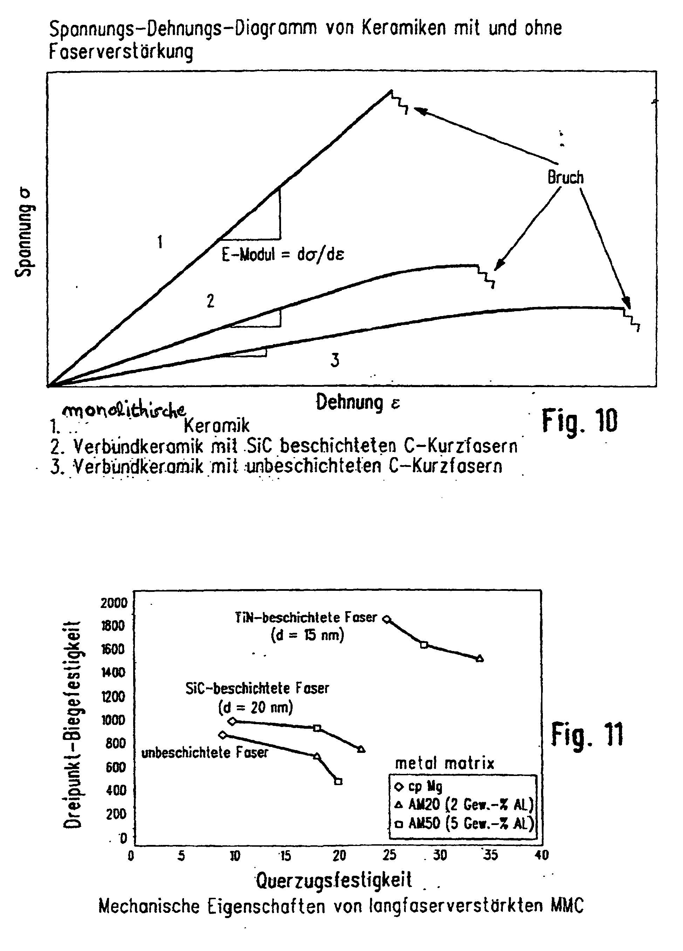

Die solcherart beschichteten Fasern bewirken in faserverstärkten Verbundwerkstoffen eine verbesserte Benetzbarkeit der Faseroberfläche durch die Matrix. Daraus folgt ein höherer Volumenanteil der Faserkomponente im Verbundwerkstoff. Die Figuren 9a und 9b zeigen einen solchen keramischen Verbundwerkstoff mit unbeschichteten Fasern (Figur 9a) und mit SiC beschichteten Fasern (Figur 9b). Der durch die Beschichtung bewirkte erhöhte Faseranteil ist deutlich zu erkennen. Der erhöhte Faseranteil bewirkt eine Duktilisierung des Verbundwerkstoffs und damit einhergehende verbesserte mechanische Eigenschaften, insbesondere die Vermeidung eines spröden Bruchs. In Figur 10 ist dies exemplarisch in Form eines Spannungs-Dehnungs-Diagramms von keramischen Verbundwerkstoffen dargestellt.

In Metallmatrix-Verbundwerkstoffen verhindert eine Beschichtung z. Bsp. aus SiC oder TiN eine Reaktion der Faseroberfläche mit der Metallschmelze (bspw. Mg- oder Mg/Al-Legierungen) während der Herstellung des Verbundwerkstoffs. Die Beschichtung dient dabei als Diffusions- und Reaktionsbarriere. Dies und die verbesserte Benetzbarkeit der Fasern durch die Matrix führt ebenfalls zu einer Verbesserung der mechanischen Eigenschaften von Metallmatrix-Verbundwerkstoffen. In Figur 11 sind die Dreipunkt-Biegefestigkeiten und die Querzugfestigkeiten verschiedener Metallmatrix-Verbundwerkstoffe bei Raumtemperatur gegeneinander aufgetragen. Dabei handelt es sich um Matrices mit unidirektionalen Wickelkörper aus Kohlenstoff-Langfasern mit einem Faservolumengehalt von 50 %. Der mit TiN-beschichteten Fasern verstärkte Verbundwerkstoff zeigt Festigkeiten, die denen von Hochleistungsstahl gleichen. Bei der Herstellung von Metallmatrix-Verbundwerkstoffen durch Gasdruckschmelzinfiltration kann der Infiltrationsdruck bis auf etwa 1/10 des üblichen Wertes (bspw. von 100 bar auf unter 10 bar) gesenkt werden.

## Patentansprüche

1. Verfahren zur Herstellung von beschichteten Kurzfasern, wobei die Kurzfasern in einem Reaktor mit mindestens einem Beschichtungsmittel beschichtet werden,
**dadurch gekennzeichnet,**
**daß** mit Schlichte bzw. einer Kunststoff-Matrix überzogene Kurzfaserbündel verwendet werden, welche zunächst einem Hochfrequenzwellen-Feld ausgesetzt werden, wodurch die Schlichte bzw. die Kunststoff-Matrix abgelöst wird und die Faserbündel in einzelne Fasern aufgespaltet werden und anschließend die so vereinzelten Fasern im Hochfrequenzwellen-Feld aus mindestens einem in der Gasphase vorliegenden Beschichtungsmittel allseitig direkt CVD-beschichtet werden.

2. Verfahren zur Herstellung von beschichteten Kurzfasern aus Endlosfasern, wobei zunächst Faserbündel aus Endlosfasern thermisch entschlichtet, die resultierenden vereinzelten Fasern anschließend beschichtet werden und die beschichteten Endlosfasern zu Kurzfasern zerschnitten werden,
**dadurch gekennzeichnet,**
**daß** die Schnittstellen der Endlosfasern nach dem Zerschneiden an den dadurch entstandenen ungeschützten Enden in einem Hochfrequenzwellen-Feld aus mindestens einem in der Gasphase vorliegenden Beschichtungsmittel CVD-beschichtet werden.

3. Verfahren nach Anspruch 1 oder 2,
**dadurch gekennzeichnet,**
**daß** Kohlenstoff-Kurzfasern, insbesondere Recyclat-Kurzfasern verwendet werden.

4. Verfahren nach einem der vorhergehenden Ansprüche,
**dadurch gekennzeichnet,**
**daß** die Kurzfaserbündel vor dem Eintrag in das Hochfrequenzwellen-Feld mechanisch aufgelockert werden.

5. Verfahren nach einem der vorhergehenden Ansprüche,
**dadurch gekennzeichnet,**
**daß** als Hochfrequenzwellenfeld ein Mikrowellenfeld verwendet wird.

6. Verfahren nach einem der vorhergehenden Ansprüche,
**dadurch gekennzeichnet,**
**daß** die Kurzfasern mit Pyro-C und/oder SiC und/oder Si beschichtet werden.

7. Verfahren nach Anspruch 6,
**dadurch gekennzeichnet,**
**daß** Kohlenstoff-Kurzfasern mit einer C-gradierten und/oder Si-gradierten Siliziumcarbid-Schicht beschichtet werden.

8. Verfahren nach Anspruch 7,
**dadurch gekennzeichnet,**
**daß** die gradierte Siliziumcarbid-Schicht in einem Beschichtungsschritt durch Variation der Abscheidungsparameter abgeschieden wird.

9. Verfahren nach einem der Ansprüche 6 bis 8,
**dadurch gekennzeichnet,**
**daß** als Beschichtungsmittel Methyltrichlorsilan/Wasserstoff verwendet wird.

10. Verfahren nach einem der Ansprüche 1 bis 5,
**dadurch gekennzeichnet,**
**daß** die Kurzfasern mit Pyro-C und/oder TiN und/oder TiCN und/oder TiC beschichtet werden.

11. Verfahren nach Anspruch 10,
**dadurch gekennzeichnet,**
**daß** Kohlenstoff-Kurzfasern mit einer C-gradierten und/oder N-gradierten Titancarbonitrid-Schicht beschichtet werden.

12. Verfahren nach Anspruch 11,
**dadurch gekennzeichnet,**
**daß** die gradierte Titancarbonitrid-Schicht in einem Beschichtungsschritt durch Variation der Abscheidungsparameter abgeschieden wird.

13. Verfahren nach einem der Ansprüche 10 bis 12,
**dadurch gekennzeichnet,**
**daß** als Beschichtungsmittel Titantetrachlorid mit Stickstoff und ggf. Methan in Wasserstoff verwendet wird.

14. Verfahren nach einem der vorhergehenden Ansprüche,
**dadurch gekennzeichnet,**
**daß** die Dicke der Beschichtung durch die Verweilzeit der Fasern im Reaktor gesteuert wird.

15. Beschichtete Kohlenstoff-Kurzfasern,
**dadurch gekennzeichnet,**
**dass** sie eine C-gradierte und Si-gradierte Schicht aufweisen, wobei die Schicht in ihrer Zusammensetzung von reinem Kohlenstoff über Siliziumcarbid zu reinem Silizium übergeht und wobei die Kohlenstoff-Kurzfasern allseitig beschichtet sind.

16. Beschichtete Kohlenstoff-Kurzfasern,
**dadurch gekennzeichnet,**
**dass** sie eine C-gradierte und/oder N-gradierte Titancarbonitril-Schicht aufweisen, wobei die Kohlenstoff-Kurzfasern allseitig beschichtet sind.

17. Verwendung der beschichteten Kohlenstoff-Kurzfasern nach einem der Ansprüche 15 oder 16 für die Herstellung von faserverstärkten Verbundwerkstoffen, insbesondere von faserverstärkten Keramischen Verbundwerkstoffen und von faserverstärkten Metallmatrix-Verbundwerkstoffen.

## Claims

1. Method for producing coated short fibres, wherein the short fibres are coated with at least one coating substance in a reactor,
**characterised in that**
short fibre bundles coated with size or a plastic matrix are used, which are first subjected to a high-frequency wave field causing the size or the plastic matrix to be detached and the fibre bundles to split into individual fibres, whereupon the fibres thus separated are directly CVD-coated on all sides in the high-frequency wave field with at least one coating substance present in the gaseous phase.

2. Method for producing coated short fibres from continuous fibres, wherein fibre bundles of continuous fibres are first thermally de-sized, whereupon the resultant separated fibres are coated and the coated continuous fibres are chopped into short fibres,
**characterised in that** the cutting points of the continuous fibres resulting from the chopping process are CVD-coated at the unprotected ends in the high-frequency wave field with at least one coating substance present in the gaseous phase.

3. Method according to claim 1 or 2,
**characterised in that**
carbon short fibres, in particular recycled carbon short fibres, are used.

4. Method according to any of the preceding claims,
**characterised in that**
the short fibre bundles are mechanically loosened before being fed into the high-frequency wave field.

5. Method according to any of the preceding claims,
**characterised in that**
a microwave field is used as the high-frequency wave field.

6. Method according to any of the preceding claims,
**characterised in that**
the short fibres are coated with pyrolytic C and/or SiC and/or Si.

7. Method according to claim 6,
**characterised in that**
carbon short fibres are coated with a C-graduated and/or an Si/graduated silicon carbide coating.

8. Method according to claim 7,
**characterised in that**
the graduated silicon carbide coating is deposited in one coating step by varying the deposition parameters.

9. Method according to any of claims 6 to 8,
**characterised in that**
methyl trichlorosilane/hydrogen is used as the coating substance.

10. Method according to any of claims 1 to 5,
**characterised in that**
the short fibres are coated with pyrolytic C and/or TiN and/or TiCN and/or TiC.

11. Method according to claim 10,
**characterised in that**
carbon short fibres are coated with a C-graduated and/or an N-graduated titanium carbonitride coating.

12. Method according to claim 11,
**characterised in that**
the graduated titanium carbonitride coating is deposited in one coating step by varying the deposition parameters.

13. Method according to any of claims 10 to 12,
**characterised in that**
titanium tetrachloride with nitrogen and optionally methane in hydrogen are used as the coating substance.

14. Method according to any of the preceding claims,
**characterised in that**
the thickness of the coating is controlled by the dwell time of the fibres in the reactor.

15. Coated carbon short fibres,
**characterised in that**
they have a C-graduated and an Si-graduated coating, the composition of the coating changing from pure carbon through silicon carbide to pure silicon and the carbon short fibres being coated on all sides.

16. Coated carbon short fibres,
**characterised in that**
they have a C-graduated and/or an N-graduated titanium carbonitride coating, the carbon short fibres being coated on all sides.

17. Use of the coated carbon short fibres according to claim 15 or 16 for producing fibre-reinforced composite materials, in particular fibre-reinforced ceramic composites and fibre-reinforced metal matrix composites.

## Revendications

1. Procédé de fabrication de fibres courtes enduites, dans lequel on enduit les fibres courtes d'au moins un agent de revêtement dans un réacteur, **caractérisé en ce qu'**on emploie des faisceaux de fibres courtes, recouverts de colle, respectivement d'une matrice plastique, que l'on expose tout d'abord à un champ d'ondes de haute fréquence, ce par quoi la colle ou la matrice plastique se détache et les faisceaux de fibres se séparent en fibres individuelles et qu'ensuite on enduit directement de tous les côtés par un procédé de dépôt chimique en phase vapeur, dans un champ d'ondes de haute fréquence, les fibres, ainsi individualisées, d'au moins un agent de revêtement présent dans la phase gazeuse.

2. Procédé de fabrication de fibres courtes enduites à partir de fibres sans fin, dans lequel on désencolle tout d'abord thermiquement des faisceaux de fibres constitués de fibres sans fin, qu'ensuite on enduit les fibres individuelles résultantes et que l'on tronçonne les fibres sans fin, enduites, pour obtenir des fibres courtes, **caractérisé en ce qu'**après le tronçonnage, on enduit par un procédé de dépôt chimique en phase vapeur les bords de tronçonnage des fibres sans fin, aux extrémités non protégées apparaissant de ce fait, dans un champ d'ondes de haute fréquence, d'au moins un agent de revêtement présent dans la phase gazeuse.

3. Procédé selon la revendication 1 ou 2, **caractérisé en ce que** l'on emploie des fibres courtes de carbone, en particulier des fibres courtes de recyclage.

4. Procédé selon l'une des revendications précédentes, **caractérisé en ce qu'**avant leur introduction dans le champ d'ondes de haute fréquence, les faisceaux de fibres courtes sont ouverts mécaniquement.

5. Procédé selon l'une des revendications précédentes, **caractérisé en ce que** comme champ d'ondes de haute fréquence on emploie un champ de micro-ondes.

6. Procédé selon l'une des revendications précédentes, **caractérisé en ce que** l'on enduit les fibres courtes de pyro-C et/ou de SiC et/ou de Si.

7. Procédé selon la revendication 6, **caractérisé en ce que** l'on enduit les fibres courtes de carbone d'une couche de carbure de silicium graduée en C et/ou en Si.

8. Procédé selon la revendication 7, **caractérisé en ce que** dans une étape du revêtement la couche de carbure de silicium graduée se dépose par variation des paramètres de dépôt.

9. Procédé selon l'une des revendications 6 à 8, **caractérisé en ce que** comme agent de revêtement on emploie le méthyltrichlorosilane / hydrogène.

10. Procédé selon l'une des revendications 1 à 5, **caractérisé en ce que** l'on enduit les fibres courtes de pyro-C et/ou de TiN et/ou TiCN et/ou TiC.

11. Procédé selon la revendication 10, **caractérisé en ce que** l'on enduit les fibres courtes de carbone d'une couche de carbonitrure de titane graduée en C et/ou graduée en N.

12. Procédé selon la revendication 11, **caractérisé en ce que**, dans une étape du revêtement, la couche de carbonitrure de titane graduée se dépose par variation des paramètres de dépôt.

13. Procédé selon l'une des revendications 10 à 12, **caractérisé en ce que** comme agent de revêtement on emploie du tétrachlorure de titane avec de l'azote et éventuellement du méthane dans l'hydrogène.

14. Procédé selon l'une des revendications précédentes, **caractérisé en ce que** l'épaisseur du revêtement est contrôlée par la durée de séjour des fibres dans le réacteur.

15. Fibres courtes de carbone enduites, **caractérisées en ce qu'**elles présentent une couche graduée en C et graduée en Si, la composition de la couche se transformant de carbone pur sur carbure de silicium en silicium pur et les fibres courtes de carbone étant enduites de tous côtés.

16. Fibres courtes de carbone enduites, **caractérisées en ce qu'**elles présentent une couche de carbonitrure de titane graduée en C et/ou graduée en N, les fibres courtes de carbone étant enduites de tous côtés.

17. Utilisation des fibres courtes de carbone enduites selon l'une des revendications 15 ou 16 pour la fabrication de matériaux composites armés de fibres, en particulier de matériaux composites céramiques armés de fibres et de matériaux composites à matrice métallique armés de fibres.
